# EUROPEAN PATENT SPECIFICATION

(11) **EP 2 400 309 B1**
(45) Date of publication and mention of the grant of the patent: **29.03.2017**
(21) Application number: 11005074.7
(22) Date of filing: 21.06.2011
(51) Int. Cl.: G01R 15/20, G01R 33/06

(54) **Current sensor**
Stromsensor
Capteur de courant

(30) Priority: 24.06.2010 JP 2010144316
(43) Date of publication of application: 28.12.2011
(73) Proprietor: Sumida Corporation, Tokyo (JP)
(72) Inventor: Miyazaki, Hiroyuki, Tokyo 103-8259 (JP)
(74) Representative: Schäfer, Matthias W.

(56) References cited:
- JP-A- 1 189 565
- JP-A- 2000 055 999
- JP-A- 2001 141 757
- JP-A- 2008 128 711
- US-A- 3 219 909

## Description

### BACKGROUND OF THE INVENTION

### 1. FIELD OF THE INVENTION

This invention relates to current sensors.

### 2. DESCRIPTION OF THE RELATED ART

An open loop current sensor has a magnetic core as a magnetic path of a loop magnetic flux generated by a current to be measured, and a Hall element is disposed in a gap of the magnetic core. The signal level of an electronic signal output from the Hall element depends on the intensity of the loop magnetic flux. Therefore, the electronic signal output from the Hall element is amplified by an amplifier circuit and output as the current value of the current to be measured (see Japanese patent application laid-open publication No. 2001-141757, for example).

### SUMMARY OF THE INVENTION

In such current sensor, variation of characteristics of the Hall element, characteristics of the magnetic core, and a position of the Hall element causes an error in the measured current value. Therefore, in order to reduce the error, the gain of the amplifier circuit is adjusted for each current sensor by adjusting circuit constants of the amplifier circuit (such as the resistance of a resistor in the amplifier circuit) when the current sensor is manufactured.

In addition, since characteristics of the Hall element dynamically changes due to change of an environmental temperature, a current sensor described in Japanese patent application laid-open publication No. 2001-141757 has a temperature-compensation circuit next to the amplifier circuit to compensate for the detected current value. However, other than such temperature variation, there are a lot of error causes such as the above-mentioned variation to be compensated to reduce the detection error of the current value. If the current sensor has respective compensation circuits to compensate for such error causes, then the circuit scale of the current sensor increases and manual adjustments are required for circuit constants of the compensation circuits.

JP 1 189565 discloses a direct-current detector to lessen a temperature drift and thereby to improve accuracy in detection.

From JP 2000 055999 is known a magnetic sensor equipment which measures a magnetic field, and the current sensor equipment which measures current by measuring the magnetic field generated by current. This current sensor equipment comprises amplifiers, a band pass filter, a low pass filter, a level comparator, a gain control and a variable gain circuit. One of the amplifiers is connected between the band pass filter and the level comparator. This disclosure uses a GMR element.

In view of the circumstances, the present invention has been conceived to obtain current sensors that automatically compensate for various sorts of error causes.

The present invention solves this subject by providing a current sensor device according to claim 1. Advantageous embodiments are claimed in the dependent claims.

In accordance with an aspect of the present invention, a current sensor has a magnetic core for conducting a magnetic flux generated by a current to be measured; a flux detector that detects the magnetic flux conducted in the magnetic core and outputs an electronic signal corresponding to the detected magnetic flux; an amplifier circuit that amplifies the electronic signal output from the flux detector; a winding that is wound around the magnetic core; a high-frequency oscillator that applies a high-frequency signal to the winding; a first filter that extracts the same frequency component as a frequency of the high-frequency signal from an output signal of the amplifier circuit; and a controller circuit that controls a gain of the amplifier circuit with taking account of the frequency component extracted by the first filter so that an amplitude of the frequency component is equal to a predetermined constant value.

The high-frequency signal is applied independently of the current to be measured. In order to remove a detection error contained of the high-frequency signal due to various sorts of error causes, the gain of the amplifier circuit is adjusted. Consequently, a detection error of the current to be measured is reduced together with the detection error of the high-frequency signal. Therefore, this current sensor automatically compensates for various sorts of error causes.

Further, in accordance with the present invention, the current sensor has a second filter that blocks a frequency component in the output signal of the amplifier circuit. The frequency component is the same as the frequency of the high-frequency signal.

Because the current sensor has a second filter, an output signal from this current sensor does not contain components corresponding to the high-frequency signal, and a next circuit of the current sensor is not required to separate components corresponding to the high-frequency signal and components corresponding to the current to be measured.

Furthermore, in accordance with the present invention, the control circuit has (a) a rectifier circuit that rectifies the frequency component extracted by the first filter; (b) a comparator circuit that outputs a control signal based on a difference between an output voltage of the rectifier circuit and a reference voltage; and (c) an electronic element that changes the gain of the amplifier circuit according to the control signal.

Furthermore, in accordance the present invention, the electronic element is a transistor that changes the gain of the amplifier circuit by changing a collector-emitter resistance thereof according to a voltage of the control signal.

Furthermore, in accordance with an aspect of the present invention, the magnetic core may be a ferrite core.

Furthermore, in accordance with the aspect of the present invention, the first filter is a high-pass filter of which a cut-off frequency is a frequency in a range between the maximum frequency of the current to be measured and the frequency of the high-frequency signal.

Furthermore, in accordance with the aspect of the present invention, the second filter may be a low-pass filter.

Furthermore, in accordance with the aspect of the present invention, the frequency of the high-frequency signal may be a frequency of ten times or more higher than the maximum frequency of the current to be measured.

Furthermore, in accordance with the aspect of the present invention, the flux detector is a Hall element.

Furthermore, in accordance with an example, the flux detector may be a coil.

These and other objects, features and advantages of the present invention will become more apparent upon reading of the following detailed description along with the accompanied drawling.

### BRIEF DESCRIPTION OF THE DRAWING

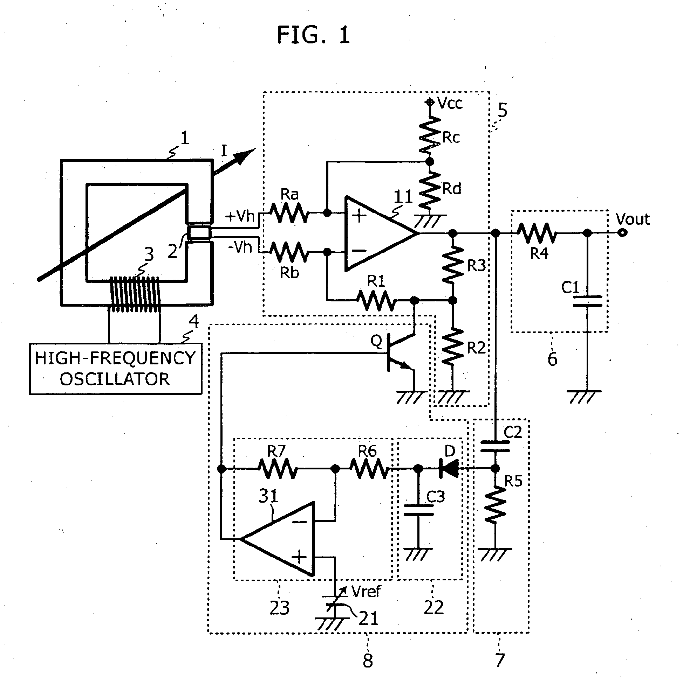

FIG. 1 is a circuit diagram that shows a configuration of a current sensor according to an embodiment of the present invention.

### DETAILED DESCRIPTION OF THE PREFERRED EMBODIMENT

Hereinafter, an embodiment according to aspects of the present invention will be explained with reference to the drawing.

FIG. 1 is a circuit diagram that shows a configuration of a current sensor according to an embodiment of the present invention.

In FIG. 1, a magnetic core 1 is a magnetic core for conducting a loop magnetic flux generated by a current I to be measured. A ferrite core, an electromagnetic steel core or the like is used as the magnetic core 1. In this embodiment, the magnetic core 1 is a C-shaped core, and a Hall element 2 is disposed in a gap of the magnetic core 1. The Hall element 2 detects the magnetic flux conducted in the magnetic core 1 and outputs an electronic signal corresponding to the detected magnetic flux.

A winding 3 is wound around the magnetic core 1. The winding 3 is wound at any position on a closed magnetic path that passes through the Hall element 2 (i.e. magnetic flux detection position). It should be noted that as shown in FIG. 1 it is preferable that a closed magnetic path of a magnetic flux generated by a current of the winding 3 is coincident with a closed magnetic path of a loop magnetic flux generated by the current I.

A high-frequency oscillator 4 generates a high-frequency signal and applies the high-frequency signal to the winding 3. In order to enable to divide an output of the Hall element 2 into components corresponding to the high-frequency signal and components corresponding to the current I, the frequency of the high-frequency signal is a frequency of ten times or more higher than the maximum frequency of the current I. If the current I is a direct current or an alternating current with the frequency of about ten kilo Herz or less, then the frequency of the high-frequency signal is, for instance, 200 kHz.

An amplifier circuit 5 is a circuit that amplifies an electronic signal output from the Hall element 2. In this embodiment, the amplifier circuit 5 is a differential amplifier circuit.

In this embodiment, the amplifier circuit 5 has an operational amplifier 11. A positive output terminal of the Hall element 2 is connected to a positive input terminal of the operational amplifier 11 through a first resistor Ra. A negative output terminal of the Hall element 2 is connected to a negative input terminal of the operational amplifier 11 through a second resistor Rb. A bias is applied to the positive input terminal of the operational amplifier 11 by a series circuit of a third resistor Rc and fourth resistor Rd between a power supply Vcc and a ground. An end of a series circuit of fifth resistor R1 and sixth resistor R2 is connected to the negative input terminal of the operational amplifier 11, and the other end of the series circuit of the fifth resistor R1 and sixth resistor R2 is connected to the ground. An end of a seventh resistor R3 is connected to a point where the fifth resistor R1 and the sixth resistor R2 are connected to each other, and the other end of the seventh resistor R3 is connected to an output terminal of the operational amplifier 11.

The sixth resistor R2 is parallel connected to a collector and an emitter of a transistor Q. Thus, the gain of the amplifier circuit 5 can be changed by changing a resistance between the collector and the emitter of the transistor Q.

A filter 6 is a circuit that blocks a frequency component in an output signal of the amplifier circuit 5, and this frequency component has the same frequency as the frequency of the high-frequency signal. In this embodiment, the filter 6 is a low-pass filter that consists of an eighths resistor R4 and a condenser C1. Although frequency components corresponding to the current I in the output signal of the amplifier circuit 5 pass through the filter 6 and are applied to an output terminal of this current sensor, frequency components corresponding to the high-frequency signal do not pass through the filter 6 and are not applied to the output terminal. The cut-off frequency of the filter 6 is set as any frequency in a range between the maximum frequency of the current I and the frequency of the high-frequency signal.

A filter 7 is a circuit that extracts the same frequency component as the frequency of the high-frequency signal from an output signal of the amplifier circuit 5. In this embodiment, the filter 7 is a high-pass filter that consists of a condenser C2 and a ninths resistor R5. Although frequency components corresponding to the high-frequency signal in the output signal of the amplifier circuit 5 pass through the filter 7 and are applied to a controller circuit 8, frequency components corresponding to the current I do not pass through the filter 7 and are not applied to the controller circuit 8. The cut-off frequency of the filter 7 is set as any frequency in a range between the maximum frequency of the current I and the frequency of the high-frequency signal.

The controller circuit 8 is a circuit that controls the gain of the amplifier circuit 5 with taking account of the frequency component extracted by the filter 7 so that an amplitude of the frequency component is equal to a predetermined constant value.

In this embodiment, the controller circuit 8 has a power supply 21, a rectifier circuit 22, a comparator circuit 23, and the transistor Q. The power supply 21 generates a reference voltage Vref. The rectifier circuit 22 rectifies an electronic signal of frequency components extracted by the filter 7. The comparator circuit 23 outputs a control signal corresponding to a difference between an output voltage of the rectifier circuit 22 and the reference voltage Vref. The transistor Q changes the gain of the amplifier circuit 5 according to the control signal.

The rectifier circuit 22 has a diode D and a condenser C3, and rectifies and smoothes an output of the filter 7. The comparator circuit 23 has an operational amplifier 31, and resistors R6 and R7. This comparator circuit 23 outputs a control signal with a voltage given by multiplying a difference between an output voltage of the rectifier circuit 22 and the reference voltage Vref by the ratio of resistances of the resistor R6 and the resistor R7. This control signal is applied between the emitter and a base of the transistor Q. Consequently, by changing the resistance between the collector and the emitter of the transistor Q corresponding to the voltage of the control, the gain of the amplifier circuit 5 is changed.

In the next part, behavior of this current sensor is explained.

When the high-frequency oscillator 4 applies a high-frequency signal to the winding 3, a magnetic flux by the high-frequency signal is conducted through the magnetic core 1 and the Hall element 2. If the current I to be measured is not zero, then a magnetic flux by the current I is also conducted through the magnetic core 1 and the Hall element 2. The Hall element 2 generates an output voltage corresponding the magnetic flux density of the conducted magnetic flux. Therefore, if the current I is not zero, then the output voltage contains frequency components corresponding to the high-frequency signal and frequency components corresponding to the current I.

The amplifier circuit 5 amplifies this output voltage of the Hall element 2 (i.e. the difference between the positive output voltage +Vh and the negative output voltage -Vh). An output voltage of the amplifier circuit 5 is applied to the filter 6 and the filter 7.

The filter 6 blocks frequency components corresponding to the high-frequency signal, and consequently, if the current I is not zero, then frequency components corresponding to the current I in the output voltage of the amplifier circuit 5 pass the filter 6, and are applied as an output voltage Vout to an output terminal of the current sensor.

On the other hand, the filter 7 blocks frequency components corresponding to the current I in the output voltage of the amplifier circuit 5; and the frequency components corresponding to the high-frequency signal pass through the filter 7, and are applied to the control circuit 8.

In the control circuit 8, the rectifier circuit 22 rectifies and smoothes the frequency components corresponding to the high-frequency signal, and the comparator circuit 23 compares an output voltage (direct voltage) of the rectifier circuit 22 and the reference voltage Vref, and controls the transistor Q to make the difference of the both voltages closer to a predetermined value.

Specifically, if the value given by subtracting the reference voltage Vref from the output voltage of the rectifier circuit 22 is greater than the predetermined value, then the voltage of the control signal is decreased, and the resistance between the collector and the emitter of the transistor Q is increased, and consequently, the gain of the amplifier circuit 5 is decreased.
Conversely, if the value given by subtracting the reference voltage Vref from the output voltage of the rectifier circuit 22 is less than the predetermined value, then the voltage of the control signal is increased, and the resistance between the collector and the emitter of the transistor Q is decreased, and consequently, the gain of the amplifier circuit 5 is increased.

In this manner, the gain of the amplifier circuit 5 is continuously controlled so that the direct voltage given by rectifying and smoothing only the frequency components corresponding to the high-frequency signal is equal to the predetermined constant value.

In the aforementioned embodiment, the current sensor has the magnetic core 1 for conducting a magnetic flux generated by the current I to be measured; the Hall element 2 that detects the magnetic flux conducted in the magnetic core 1 and outputs an electronic signal corresponding to the detected magnetic flux; the amplifier circuit 5 that amplifies the electronic signal output from the Hall element 2; the winding 3 that is wound around the magnetic core 1; the high-frequency oscillator 4 that applies a high-frequency signal to the winding 3; the filter 7 that extracts the same frequency component as a frequency of the high-frequency signal from an output signal of the amplifier circuit 5; and the controller circuit 8 that controls the gain of the amplifier circuit 5 with taking account of the frequency component extracted by the filter 7 so that an amplitude of the frequency component is equal to a predetermined constant value.

The high-frequency signal is applied independently of the current I to be measured. In order to remove a detection error of the high-frequency signal due to various sorts of error causes, the gain of the amplifier circuit 5 is adjusted. Consequently, a detection error of the current I to be measured is reduced together with the detection error of the high-frequency signal. Therefore, this current sensor automatically compensates for various sorts of error causes such as manufacturing error, environmental change, and aging. If the magnetic core 1 is a ferrite core, then magnetic saturation due to the large current I in the magnetic core 1 is an error cause. An error due to such magnetic saturation is also automatically compensated for.

Further, in the aforementioned embodiment, the filter 6 blocks a frequency component in the output signal of the amplifier circuit 5. This frequency component has the same frequency as the frequency of the high-frequency signal. Therefore, an output signal from this current sensor does not contain components corresponding to the high-frequency signal, and a next circuit of the current sensor is not required to separate components corresponding to the high-frequency signal and components corresponding to the current I to be measured.

The description of the present invention has been presented for purposes of illustration and description, and is only limited by the claims. Many modifications and variations will be apparent to those of ordinary skill in the art.

For example, in the aforementioned embodiment, the magnetic core 1 may be a ring-shaped core.

Further, in the aforementioned embodiment, a voltage divider circuit may be disposed next to the amplifier circuit of which the gain is fixed as a constant, and the transistor Q may adjust the voltage division ratio of the voltage divider circuit. In this case, the gain of the amplifier circuit is substantially adjusted.

Furthermore, in the aforementioned embodiment, the transistor Q may be a bipolar transistor, a field effect transistor (FET), or the like.

This invention is applicable to isolated current sensors.

## Claims

1. A current sensor, comprising:
a magnetic core (1) for conducting a magnetic flux generated by a current to be measured;
a flux detector that detects the magnetic flux conducted in the magnetic core (1) and outputs an electronic signal corresponding to the detected magnetic flux;
an amplifier circuit (5) that amplifies the electronic signal output from the flux detector;
a winding (3) that is wound around the magnetic core (1); and
a first filter (7);
the first filter (7) for extracting the same frequency component as a frequency of the high-frequency signal from an output signal of the amplifier circuit (5), the first filter (7) being a high-pass filter having a cut-off frequency in a range between the maximum frequency of the current to be measured and the frequency of the high-frequency signal;
a high-frequency oscillator (4) for applying a high-frequency signal to the winding (3); wherein
the amplifier circuit (5) has an operational amplifier (11), wherein a positiv output terminal of the Hall element (2) is connected to a positive input terminal of the operational amplifier (11) through a first resistor (Ra), and a negative output terminal of the Hall element (2) is connected to a negativ input terminal of the operational amplifier (11) through a second resistor (Rb), wherein a bias is applied to the positive input terminal of the operational amplifier (11) by a series circuit of a third resistor (Rc) and a fourth resistor (Rd) between a power supply (Vcc) and a ground, wherein an end of a series circuit of a fifth resistor (R1) and a sixth resistor (R2) is connected to the negative input terminal of the operational amplifier (11), and the other end of the series circuit of the fifth resistor (R1) and the sixth resistor (R2) is connected to the ground, and wherein an end of a seventh resistor (R3) is connected to a point where the fifth resistor (R1) and the sixth resistor (R2) are connected to each other, and the other end of the seventh resistor (R3) is connected to an output terminal of the operational amplifier 11,
the current sensor further comprising
a controller circuit (8) for controling a gain of the amplifier circuit (5) with taking account of the frequency component extracted by the first filter (7) so that an amplitude of the frequency component is equal to a predetermined constant value; wherein
the flux detector being a Hall element (2), and
wherein the control circuit (8) has (a) a rectifier circuit (22) that rectifies the frequency component extracted by the first filter (7); (b) a comparator circuit (23) that outputs a control signal based on a difference between an output voltage of the rectifier circuit (22) and a reference voltage (21); and (c) a transistor (Q) that changes the gain of the amplifier circuit (5) according to the control signal, wherein the control signal is applied between the emitter and a base of the transistor (Q), wherein the sixth resistor (R2) connected to ground is parallel connected to the collector and the emitter of the transistor (Q), thus, the gain of the amplifier circuit 5 being changeable by the change of a resistance between the collector and the emitter of the transistor (Q).

2. The current sensor according to claim 1, further comprising:
a second filter (6) that blocks a frequency component in the output signal of the amplifier circuit (5), the frequency component being the same as the frequency of the high-frequency signal.

3. The current sensor according to claim 1, wherein:
the magnetic core (1) is a ferrite core.

4. The current sensor according to claim 2, wherein:
the second filter (6) is a low-pass filter.

5. The current sensor according to claim 1, wherein:
the frequency of the high-frequency signal is a frequency of ten times or more higher than the maximum frequency of the current to be measured.

## Patentansprüche

1. Stromsensor, aufweisend:
einen magnetischen Kern (1) zum Leiten eines von einem zu messenden Strom erzeugten magnetischen Fluxes;
einen Flux-Detektor, welcher den in dem magnetischen Kern (1) geleiteten magnetischen Flux erfasst und ein elektronisches Signal ausgibt, welches dem erfassten magnetischen Flux entspricht;
eine Verstärkerschaltung (5), welche das von dem Flux-Detektor ausgegebene elektronische Signal verstärkt;
eine Wicklung (3), welche um den magnetischen Kern (1) gewickelt ist; und einen ersten Filter (7);
der erste Filter (7) zum Extrahieren derselben Frequenzkomponente wie eine Frequenz des Hochfrequenz-Signals von einem Ausgangssignal der Verstärkerschaltung (5), wobei der erste Filter (7) ein Hochpass-Filter mit einer Grenzfrequenz in einem Bereich zwischen der maximalen Frequenz des zu messenden Stroms und der Frequenz des Hochfrequenz-Signals ist;
einen Hochfrequenz-Oszillator (4) zum Anlegen eines Hochfrequenz-Signals an die Wicklung (3);
wobei die Verstärkerschaltung (5) einen Operationsverstärker (11) besitzt, wobei ein positiver Ausgangsanschluss des Hall-Elements (2) mit einem positiven Eingangsanschluss des Operationsverstärkers (11) über einen ersten Widerstand (Ra) verbunden ist, und ein negativer Ausgangsanschluss des Hall-Elements (2) mit einem negativen Eingangsanschluss des Operationsverstärkers (11) über einen zweiten Widerstand (Rb) verbunden ist, wobei eine Vorspannung an den positiven Eingangsanschluss des Operationsverstärkers (11) durch eine Reihenschaltung eines dritten Widerstands (Rc) und eines vierten Widerstands (Rd) zwischen einer Spannungsversorgung (Vcc) und einer Erde angelegt wird, wobei ein Ende einer Reihenschaltung eines fünften Widerstands (R1) und eines sechsten Widerstands (R2) mit dem negativen Eingangsanschluss des Operationsverstärkers (11) verbunden ist und das andere Ende der Reihenschaltung des fünften Widerstands (R1) und des sechsten Widerstands (R2) mit der Erde verbunden ist, und wobei ein Ende eines siebten Widerstands (R3) mit einem Punkt verbunden ist, wo der fünfte Widerstand (R1) und der sechste Widerstand (R2) miteinander verbunden sind, und das andere Ende des siebten Widerstands (R3) mit einem Ausgangsanschluss des Operationsverstärkers (11) verbunden ist,
wobei der Stromsensor weiter Folgendes aufweist:
eine Regelschaltung (8) zum Regeln einer Verstärkung der Verstärkerschaltung (5) unter Berücksichtigung der durch den ersten Filter (7) extrahierten Frequenzkomponente, so dass eine Amplitude der Frequenzkomponente gleich einem vorgegebenen konstanten Wert ist;
wobei der Fluss-Detektor ein Hall-Element (2) ist, und
wobei die Regelschaltung (8) (a) eine Gleichrichterschaltung (22), welche die durch den ersten Filter (7) extrahierte Frequenzkomponente gleichrichtet; (b) eine Vergleichsschaltung (23), welche ein Regelsignal basierend auf einer Differenz zwischen einer Ausgangsspannung der Gleichrichterschaltung (22) und einer Referenz-Spannung (21) ausgibt; und (c) einen Transistor (Q) aufweist, welcher die Verstärkung der Verstärkerschaltung (5) gemäß dem Regelsignal ändert, wobei das Regelsignal zwischen dem Emitter und einer Basis des Transistors (Q) angelegt ist, wobei der mit Erde verbundene sechste Transistor (R2) parallel mit dem Kollektor und dem Emitter des Transistors (Q) verbunden ist, wobei somit die Verstärkung der Verstärkerschaltung (5) durch die Änderung eines Widerstandes zwischen dem Kollektor und dem Emitter des Transistors (Q) veränderbar ist.

2. Stromsensor nach Anspruch 1, weiter aufweisend:
einen zweiten Filter (6), welcher eine Frequenzkomponente im Ausgangssignal der Verstärkerschaltung (5) blockiert, wobei die Frequenzkomponente dieselbe ist wie die Frequenz des Hochfrequenz-Signals.

3. Stromsensor nach Anspruch 1, wobei:
der magnetische Kern (1) ein Ferritkern ist.

4. Stromsensor nach Anspruch 2, wobei:
der zweite Filter (6) ein Tiefpass-Filter ist.

5. Stromsensor nach Anspruch 1, wobei:
die Frequenz des Hochfrequenz-Signals eine Frequenz ist, welche zehn Mal oder mehr höher als die maximale Frequenz des zu messenden Stroms ist.

## Revendications

1. Un capteur de courant comprenant :
un noyau magnétique (1) pour conduire le flux magnétique généré par un courant devant être mesuré ;
un détecteur de flux qui détecte le flux magnétique conduit dans le noyau magnétique (1) et émet un signal électronique correspondant au flux magnétique détecté ;
un circuit amplificateur (5) qui amplifie le signal électronique émis par le détecteur de flux ;
un enroulement (3) bobiné autour du noyau magnétique (1) ; et
un premier filtre (7) ;
le premier filtre (7) étant conçu pour extraire le composant avec une fréquence identique à la fréquence du signal haute-fréquence d'un signal émis du circuit amplificateur (5), le premier filtre (7) étant un filtre passe-haut présentant une fréquence de coupure située entre la fréquence maximale du courant devant être mesuré et la fréquence du signal haute fréquence ;
un oscillateur à haute fréquence (4) conçu pour appliquer un signal haute fréquence sur l'enroulement (3) ; étant précisé que
le circuit amplificateur (5) présente un amplificateur opérationnel (11), étant précisé qu'une borne de sortie positive de l'élément à effet Hall (2) est connectée à une borne d'entrée positive de l'amplificateur opérationnel (11) via une première résistance (Ra), et une borne de sortie négative de l'élément à effet Hall (2) est connectée à une borne d'entrée négative de l'amplificateur opérationnel (11) via une seconde résistance (Rb), étant précisé qu'un biais est appliqué à la borne d'entrée positive de l'amplificateur opérationnel (11) par un circuit en série composé d'une troisième résistance (Rc) et d'une quatrième résistance (Rd) entre une alimentation électrique (Vcc) et une terre, étant précisé qu'une extrémité d'un circuit en série composé d'une cinquième résistance (R1) et d'une sixième résistance (R2) est connectée à la borne d'entrée négative de l'amplificateur opérationnel (11), et l'autre extrémité d'un circuit en série composé de la cinquième résistance (R1) et de la sixième résistance (R2) est connectée à la terre, et étant précisé qu'une extrémité d'une septième résistance (R3) est connectée à un point où la cinquième résistance (R1) et la sixième résistance (R2) sont connectées l'une à l'autre, et l'autre extrémité de la septième résistance (R3) est connectée à une borne de sortie de l'amplificateur opérationnel (11),
le capteur de courant comprenant en outre
un circuit de contrôle (8) pour contrôler le gain du circuit d'amplificateur (5) en tenant compte du composant de fréquence extrait par le premier filtre (7) de sorte qu'une amplitude de l'élément de fréquence soit égale à une valeur prédéfinie constante ; étant précisé que
le détecteur de flux est un élément à effet Hall (2), et
étant précisé que le circuit de contrôle (8) présente (a) un circuit redresseur (22) qui redresse le composant de fréquence extrait par le premier filtre (7) ; (b) un circuit comparateur (23) qui émet un signal de contrôle basé sur une différence entre une tension de sortie du circuit redresseur (22) et une tension de référence (21) ; et (c) un transistor (Q) qui modifie le gain du circuit amplificateur (5) en fonction du signal de contrôle, étant précisé que le signal de contrôle est appliqué entre l'émetteur et une base du transistor (Q), étant précisé que la sixième résistance (R2) connectée à la terre est connectée en parallèle au collecteur et à l'émetteur du transistor (Q), ce qui a pour conséquence que le gain du circuit amplificateur (5) est modifiable par le changement d'une résistance entre le collecteur et l'émetteur du transistor (Q).

2. Le capteur de courant conformément à la Revendication 1 comprenant en outre :
un second filtre (6) qui bloque un composant de fréquence dans le signal de sortie du circuit amplificateur (5), le composant présentant une fréquence identique à la fréquence du signal haute-fréquence.

3. Le capteur de courant conformément à la Revendication 1, étant précisé que :
le noyau magnétique (1) est un noyau en ferrite.

4. Le capteur de courant conformément à la Revendication 2, étant précisé que :
le second filtre (6) est un filtre passe-bas.

5. Le capteur de courant conformément à la Revendication 1, étant précisé que :
la fréquence du signal haute-fréquence est une fréquence dix fois ou plus supérieure à la fréquence maximale devant être mesurée.
